# EUROPEAN PATENT SPECIFICATION

(11) **EP 1 573 754 B1**
(45) Date of publication and mention of the grant of the patent: **29.06.2016**
(21) Application number: 03775734.1
(22) Date of filing: 05.12.2003
(51) Int. Cl.: H01F 17/00, H01L 23/522

(54) **A PLANAR INDUCTIVE COMPONENT AND AN INTEGRATED CIRCUIT COMPRISING A PLANAR INDUCTIVE COMPONENT**
PLANARES INDUKTIVES BAUELEMENT UND INTEGRIERTE SCHALTUNG MIT EINEM PLANAREN INDUKTIVEN BAUELEMENT
COMPOSANT INDUCTIF PLAN ET CIRCUIT INTEGRE COMPRENANT UN COMPOSANT INDUCTIF PLAN

(30) Priority: 13.12.2002 EP 02080328
(43) Date of publication of application: 14.09.2005
(73) Proprietor: NXP B.V., 5656 AG Eindhoven (NL)
(72) Inventor: TIEMEIJER, Lukas, F., NL-5656 AA Eindhoven (NL); HAVENS, Ramon, J., NL-5656 AA Eindhoven (NL); LEENAERTS, Dominicus, M., W., NL-5656 AA Eindhoven (NL); PAVLOVIC, Nenad, NL-5656 AA Eindhoven (NL); VEENSTRA, Hugo, NL-5656 AA Eindhoven (NL); VAN DER HEIJDEN, Edwin, NL-5656 AA Eindhoven (NL)
(74) Representative: Miles, John Richard
(86) International application number: PCT/IB2003/005819
(87) International publication number: WO 2004/055839

(56) References cited:
- US-A1- 2002 074 620
- US-A1- 2002 086 585
- US-A1- 2002 130 387

## Description

The invention relates to a planar inductive component comprising:
- a winding situated in a first plane,
- a patterned ground shield for shielding the winding from a further layer,

The invention further relates to an integrated circuit comprising a substrate and a planar inductive component.

Such a planar inductive component is disclosed in International Patent Application published under number WO 98/50956. Such planar inductive components are widely used in for instance integrated circuits operating at RF frequencies. Applications of such circuits are to be found in for instance wireless communication devices, such as cellular phones and wireless LAN stations.

The disclosed planar inductive component is part of an integrated circuit. The patterned ground shield of the planar inductive component is situated between its winding and the semiconductor substrate on which the planar inductive component is formed. The disclosed patterned ground shield is essentially a sheet of conductive material that in operation is connected to a DC voltage source supplying a fixed voltage.

A first purpose of the ground shield as disclosed in WO 98/50956 is to shield the winding from the substrate. Without any additional measures a mirror current will flow into the sheet, which reduces the effective inductance of the inductive component and limits its quality factor. Therefore, a second purpose of the ground shield as disclosed in WO 98/50956 is to prevent these mirror currents from flowing. This is achieved by patterning the ground shield in such a way that no closed loops occur in which such mirror currents may flow. Still a disadvantage of the known planar inductive component is that it has a relatively low quality factor.

Among other things it is an object of the invention to provide a planar inductive component having a high quality factor.

According to a first aspect of the invention there is provided a planar inductive component comprising:
a winding situated in a first plane,
a patterned ground shield for shielding the winding from a further layer, wherein
said winding Is at least substantially symmetrical with respect to a mirror plane perpendicular to said first plane, and said winding comprises a first at least substantially spiral-shaped sub-winding with a first center, a second at least substantially spiral-shaped sub-winding with a second center, said first and second centers coinciding with each other, the shape of said second sub-winding being a mirror-image of the shape of said first sub-winding, and said first and second sub-windings being electrically connected in series, and
said patterned ground shield comprises a plurality of electrical conductive first tracks situated in a first ground shield plane In parallel with said first plane, said first tracks having an orientation perpendicular to said mirror plane, wherein each first track extends from one side of the mirror plane to the other side of the mirror plane.
The invention is based on the insight that the quality factor of a planar inductive component may be limited by current crowding in the winding and by the resistance within the patterned ground shield. The symmetry of the winding ensures that the current within the tracks of the winding is distributed evenly. Thus current crowding leading to an effectively higher resistivity of the tracks within the winding, Is prevented. This in itself improves the attainable quality factor of the inductive component according to the invention.
In a normal mode of operation a differential voltage Is applied to the winding. Due to its symmetry the voltage at a location in the winding at one side of the mirror plane will be equal in magnitude but different in sign from the voltage at the corresponding mirrored location at the other side of the mirror plane. Therefore, the charges in one of the first tracks of the patterned ground shield, induced by these voltages via the parasitic capacitances between the winding and the patterned ground shield, will be equal in magnitude and different in sign as well. Due to the alternating nature of the applied voltage, the voltages at said location and its corresponding mirror location in the winding will change over time, but will remain equal in magnitude and opposite in sign.
This will be the case for all locations In the winding on one side of said mirror plane and the corresponding mirror locations on the other side of the mirror plane. Therefore, the charge induced in one of the first tracks on one side of said mirror Image will be balanced by the charge Induced In the same one of the first tracks on the other side of the mirror plane. Further the orientation of the first tracks ensures that currents flowing due to alternating induced currents will flow through the shortest possible path, the path with the least resistance. Hereby the effective resistance of the patterned ground shield is minimized, while at the same time mirror currents are prevented. Due to the presence of parasitic capacitances It is advantageous that the patterned ground shield is symmetric with respect to the mirror plane.
It will be clear that the operation of the patterned ground shield essentially remains the same if the winding is not exactly symmetrical. For instance for this purpose a spiral-shaped winding may be considered being substantially symmetrical.
An embodiment of the planar inductive component according to the invention is characterized by said patterned ground shield which comprises a second conductive track with an orientation in parallel with said first plane, is symmetrical with respect to said mirror plane, and is electrically coupled to said first tracks. An advantage of this embodiment is that the first tracks in the patterned ground shield will all have the same DC potential. Although this is not strictly required, since in operation no charge transfer takes place between the first tracks of the patterned ground shield, in practice it is desirable to have the first tracks at the same DC potential. By electrically coupling said second track to a DC source or a known DC potential, for instance ground, the DC potential of the patterned ground shield in operation may be defined. In practice it may be advantageous that the second track is situated in the first ground shield plane.
In practice It may be advantageous to use a multi-layer patterned ground shield. For instance in an integrated circuit different layers of conductive material with different conductivities are available, which may be utilized. Thus a first layer may be used for the first tracks, while another layer may be used for the further tracks. By electrically interconnecting the first and further tracks, a composite track Is created with effectively a lower resistivity than either the first or further tracks. This increases the effectivity of the ground shield, resulting in a planar inductive component with a higher quality factor.
Another further embodiment of the planar inductive component according to the invention is characterized by said winding comprising a first at least substantially spiral- shaped sub-winding with a first center intertwined with a second at least substantially spiral- shaped sub-winding with a second center, said first and second centers coinciding with each other, the shape of said second sub-winding being a mirror-image of the shape of said first sub-winding, and said first and second sub-windings being electrically connected in series.
A planar inductive component comprising such a first spiral-shaped sub- winding intertwined with such a second spiral-shaped sub-winding Is an advantageous way to
realize a multi winding inductive component in which the current distribution is evenly distributed within the tracks of the sub-winding. In practice it is usually difficult to obtain spiral-shaped tracks. However substantially spiral-shaped tracks, for instance in the form resembling that of an octagon, are easily obtainable.
Another further embodiment of the planar inductive component according to the invention is characterized by said winding being substantially circular. A substantially circular winding is advantageous, because of its Inherent symmetry.
An integrated circuit according to the invention comprises a substrate, a planar inductive component according to the invention in which said further layer Is the substrate.
The inductive component according to the invention can advantageously be used in integrated circuits. Any of the layers available in a regular IC process that may be used for realizing electrically conductive interconnections between or within integrated semiconductor devices may be used for either said winding or said patterned ground shield.
US 2002/086585 A1 discloses the preamble of claim 1 and an insulation device intended to prevent the propagation of electromagnetic radiation produced by at least one electric element integrated with a low-resistivity substrate, said insulation device being robust and having uniform isolation properties in space. An insulation device according to the invention includes a plurality of isolation trenches which stretch out in the substrate and are substantially parallel to each other, and a plurality of series of Isolation transverses having a depth which is close to that of said isolation trenches, said trenches and said series of transverses containing a resistive material having a higher resistivity than the resistivity of the substrate, each series of transverses being realized transversely between two adjacent isolation trenches and arranged so that two transverses included between two adjacent series are not each other's extension.
US 2002/074620 A1 discloses that an integrated circuit inductor structure has a substrate disposed below an inductor. The structure also has plural conductive segments located between the substrate and the inductor. The conductive segments connect at substantially a point below the center of the inductor.
The above and other objects and features of the present invention will become more apparent from the following detailed description considered in connection with the accompanying drawings in which:
Fig. 1 shows a diagram of a top view of an embodiment of a planar inductive component according to the invention;
Figs. 2A-B show diagrams of top views of further embodiments of planar inductive components according to the invention;
Figs. 3A-B show diagrams of cross sections of the further embodiments of the planar inductive components shown in Fig. 2A-B;
Figs. 4A-B show electrical schematics of lumped element models of the further embodiments of the planar inductive components shown in Figs. 2A-B;
Figs. 5A-F show diagrams of top views and cross sections of further embodiments of the patterned ground shield of a planar inductive component according to the invention;
Figs. 6A-B show diagrams of top views of further embodiments of a winding of planar inductive components according to the invention;
Fig. 7 shows a diagram of a top view of another further embodiment of a winding of a planar inductive component according to the invention;
Fig. 8 shows a schematic diagram of an integrated circuit comprising planar inductive components according to the invention.

In these Figures identical parts are identified by identical references.

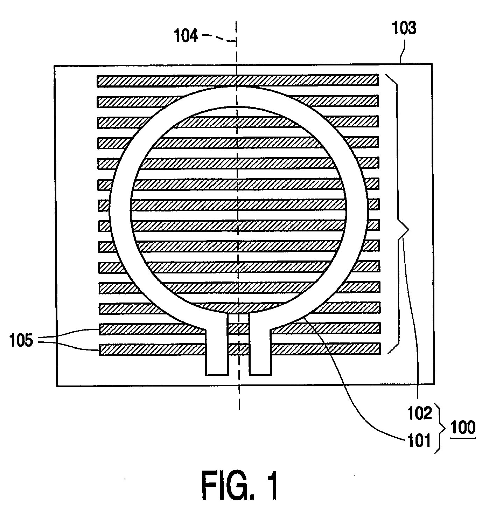

Fig. 1 shows a diagram of a top view of an embodiment of a planar inductive component according to the invention. The planar inductive component 100 shown comprises a winding 101 and a patterned ground shield 102. The planar inductive component 100 is situated on top of a further layer, a substrate 103. The winding 101 is basically a track of conductive material, e.g. aluminum, that forms a loop that is substantially circular. It is symmetrical with respect to a mirror plane 104 that has an orientation perpendicular to the surface of the substrate 103. The patterned ground shield is situated between the winding 101 and the substrate 103. The ground shield 102 comprises a plurality of tracks 105 of a conductive material, e.g. aluminum or poly-silicon. The tracks 105 are situated in a plane in parallel with the surface of the substrate and have an orientation perpendicular to the mirror plane 104.

The voltage difference has a maximum value at the terminals of the planar inductive component 100. Therefore, the charges induced in the patterned ground shield have a maximum (in absolute value) at these locations too. The charges induced have an opposite sign. Therefore, the charge redistribution that takes place in a direction perpendicular to the mirror plane 104 has to be as "easy" as possible. A low resistance is realized by a conductive path that is shortest possible, thus by means of the first tracks 105.

For differential-mode operation it may be advantageous to provide a center tap that is electrically connected to the winding 101 and is symmetrical with respect to the mirror plane 104. This effectively divides the winding 101 into two symmetrical sub-windings with otherwise identical properties.

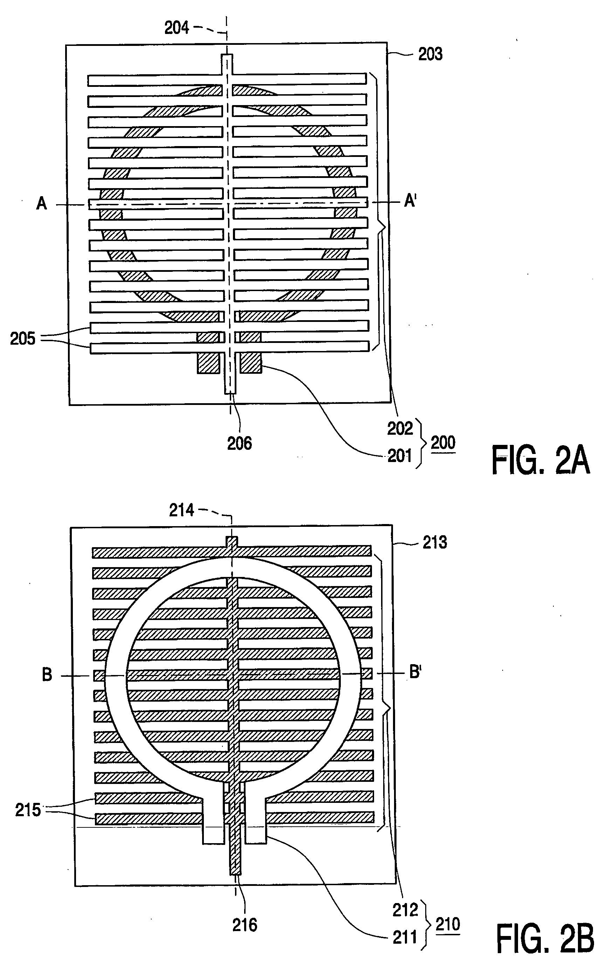

Figs. 2A-B show diagrams of top views of further embodiments of planar inductive components according to the invention. Fig. 2A shows a planar inductive component 200 comprising a winding 201 and a patterned ground shield 202. The winding 201 is situated between the patterned ground shield 202 and the substrate 203. The patterned ground shield 202 and the winding 201 are situated in planes that are parallel with respect to each other and the surface of a substrate 203. The winding 201 is a loop with a substantially circular shape that is symmetrical with respect to a mirror plane 204 that is perpendicular to the surface of the substrate 203. The patterned ground shield 202 comprises a plurality of first tracks with an orientation perpendicular to the mirror plane 204. The first tracks 205 are mutually connected by means of a second track with an orientation in parallel with the mirror plane 204. The second track 206 is symmetrical with respect to the mirror plane 204.

Fig. 2B shows a planar inductive component 210 comprising a winding 211 and a patterned ground shield 212. The patterned ground shield 212 is situated between the winding 211 and the substrate 213. The patterned ground shield 212 and the winding 211 are situated in planes that are parallel with respect to each other and the surface of a substrate 213. The winding 211 is a loop with a substantially circular shape that is symmetrical with respect to a mirror plane 214 that is perpendicular to the surface of the substrate 213. The patterned ground shield 212 comprises a plurality of first tracks with an orientation perpendicular to the mirror plane 214. The first tracks 215 are mutually connected by means of a second track with an orientation in parallel with the mirror plane 214. The second track 216 is symmetrical with respect to the mirror plane 214.

It may be advantageous to use the second tracks 206, 216 to ensure that the first tracks 205, 215 are, in operation, all on the same DC potential. Further the second tracks 206, 216 may be advantageous if the planar inductive components are not driven exactly differentially.

It is advantageous if the first and second tracks have a small width in comparison with the diameter of the winding, preferably the width should be less than 10 percent of the diameter of the winding. In a practical situation the first tracks 205, 215 may have a width of about 20 microns and a spacing of about 2 microns. The second tracks 206, 216 may have a width of about 20 microns. A typical diameter of the windings 201, 211 is about 300 microns.

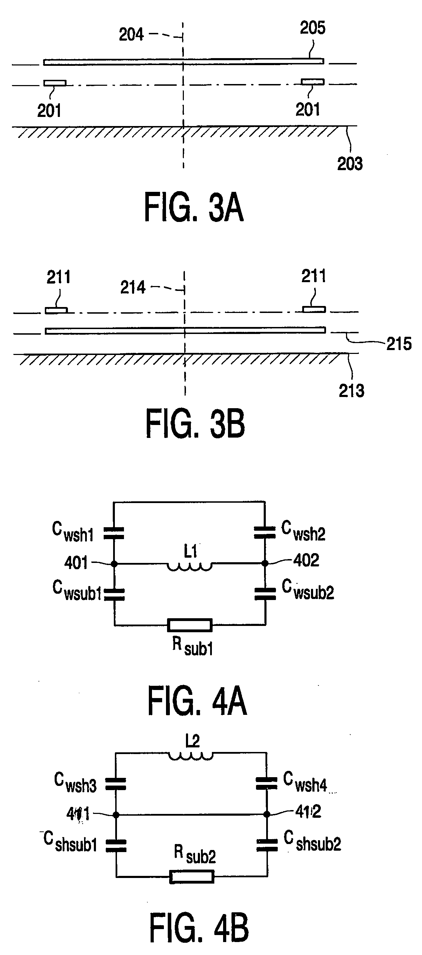

Figs. 3A-B show diagrams of cross sections of the further embodiments of the planar inductive components shown in Figs. 2A-B. Fig. 3A shows a cross section of the planar inductive component 200 and the substrate 203 along the plane AA' depicted in Fig. 2A. The winding 201 is situated above the substrate 203 in a plane that has an orientation in parallel with the surface of the substrate 203. One of the first tracks 205 of the patterned ground shield 202 is situated above the winding 201 in a plane with an orientation parallel to the surface of the substrate 213. Both the winding 201 and the first tracks 205 are symmetrical with respect to the mirror plane 204 that has an orientation perpendicular to the surface of the substrate 203.

Fig. 3B shows a cross section of the planar inductive component 210 and the substrate 213 along the plane BB' depicted in Fig. 2B. One of the first tracks 215 of the patterned ground shield 212 is situated above the substrate 213 in a plane with an orientation parallel to the surface of the substrate 213. The winding 211 is situated above the patterned ground shield 212 in a plane that has an orientation parallel to the surface of the substrate 213. Both the winding 211 and the first tracks 215 are symmetrical with respect to the mirror plane 214 that has an orientation perpendicular to the surface of the substrate 213.

The windings 201, 211 of the planar inductive components shown in Figs. 2A-B, and Fig. 3A-B respectively are separated from their respective patterned ground shields 205, 215 each by a layer of a first electrical non-conductive material with a certain dielectric constant. In a similar way the winding 201 and the patterned ground shield 212 are separated from the respective substrates 203, 213 by means of another layer of a second electrical non-conductive material with another dielectric constant. Therefore, the windings 201, 211 are capacitively coupled to the respective patterned ground shields 202, 212. The winding 201 is capacitively coupled to the substrate 203 and the patterned ground shield 212 is capacitively coupled to the substrate 213. The extent of the capacitive couplings depends on the thickness of the layers and the dielectric constants of the materials applied. Furthermore, the substrate material of the substrates 203, 213 has a certain electric resistivity.

Figs. 4A-B show electrical schematics of lumped element models of the further embodiments of the planar inductive components shown in Figs. 2A-B. Fig. 4A shows the schematic of a lumped element model of the planar inductive component shown in Figs. 2A and 3A. The winding 201 is represented by the inductor L1 with a first terminal connected to node 401 and a second terminal connected to node 402. The capacitive coupling between the winding 201 and the patterned ground shield 202 is represented by the parasitic capacitance Cwsh1, with a first terminal connected to node 401, and capacitance Cwsh2, with a first terminal connected to node 402. The patterned ground shield 202 is represented by a short connecting a second terminal of Cwsh1 with a second terminal of Cwsh2. The capacitive coupling between the winding 201 and the substrate 203 is represented by the parasitic capacitance Cwsub1, with a first terminal connected to node 401, and parasitic capacitance Cwsub2, with a first terminal connected to node 402. The electrical resistance of the substrate is represented by the substrate resistance Rsub1 with a first terminal connected to a second terminal of Cwsub1 and a second terminal connected to a second terminal of Cwsub2.

Depending on the extent of capacitive coupling between, on the one hand, the winding 201 and the patterned ground shield 202 and the winding 201 and the substrate 203, on the other hand, and thus of the values of the parasitic capacitances Cwsh1, Cwsh2, Cwsub1, and Cwsub2, the configuration shown in Fig. 2A and Fig. 3B may provide an inductive component with a patterned ground shield effectively shielding the winding from the substrate.

Fig. 4B shows the schematic of a lumped element model of the planar inductive component shown in Figs. 2B and 3B. The winding 211 is represented by the inductor L2 with a first terminal connected to node 411 and a second terminal connected to node 412. The capacitive coupling between the winding 211 and the patterned ground shield 212 is represented by the parasitic capacitance Cwsh3, with a first terminal connected to node 411, and capacitance Cwsh4, with a first terminal connected to node 412. The patterned ground shield 212 is represented by a short connecting a second terminal of Cwsh3 with a second terminal of Cwsh4. The capacitive coupling between the patterned ground shield 212 and the substrate 213 is represented by the parasitic capacitance Cshsub1, with a first terminal connected to the short representing the patterned ground shield 212, and parasitic capacitance Cshsub2, with a first terminal connected to the short representing the patterned ground shield 212. The electrical resistance of the substrate is represented by the substrate resistance Rsub2 with a first terminal connected to a second terminal of Cshsub1 and a second terminal connected to a second terminal of Cshsub2.

The patterned ground shield 212 effectively eliminates the influence of the parasitic capacitances Cshsub1 and Cshsub2, and the substrate resistance Rsub2. Although the effective overall parasitic capacitance, represented by Cwsh3 and Cwsh4, in parallel with the self-inductance L2, will be somewhat higher than without the patterned ground shield, the quality factor of the inductive component will be higher, because the influence of the substrate resistance, represented by Rsub2, is eliminated.

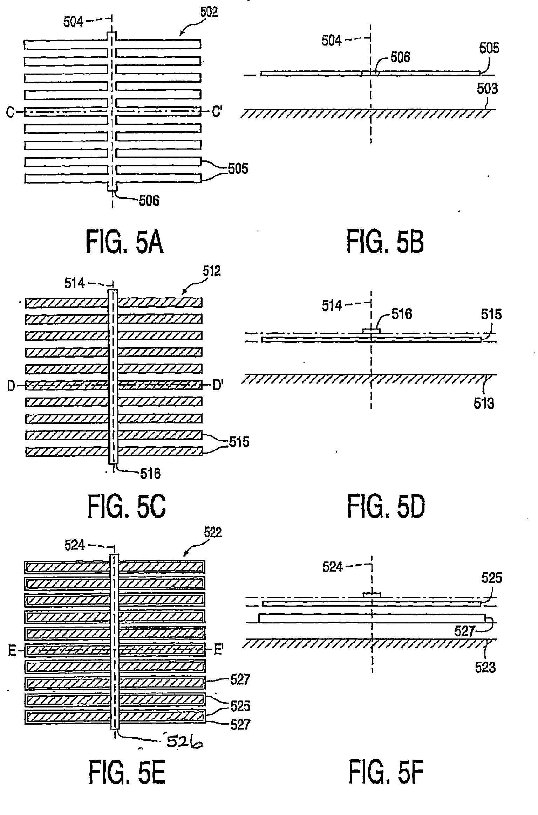

Figs. 5A-F show diagrams of top views and cross sections of further embodiments of the patterned ground shield of a planar inductive component according to the invention. The patterned ground shield 502 shown in top view in Fig. 5A comprises a plurality of first tracks 505 that are symmetrical with respect to a mirror plane 504 and have an orientation perpendicular to the mirror plane 504. The patterned ground shield 502 further comprises a second track 506 with an orientation in parallel with the mirror plane 504, further being symmetrical with respect to the mirror plane 504. The first tracks 505 and the second track 506 are situated in the same plane. The second track 506 intersects the first tracks 505. Fig. 5B shows a cross section of the planar inductive component 502 along a plane CC' depicted in Fig. 5A. Fig. 5B shows that the first track 505 and the second track 506 are symmetrical with respect to the mirror plane 504 and have an orientation in parallel with a substrate 503.

The patterned ground shield 512 shown in top view in Fig. 5C comprises a plurality of first tracks 515 that are symmetrical with respect to a mirror plane 514 and have an orientation perpendicular to the mirror plane 514. The patterned ground shield 512 further comprises a second track 516 with an orientation in parallel with the mirror plane 514, further being symmetrical with respect to the mirror plane 514. The first tracks 515 and the second track 516 are situated in different planes that are parallel to each other. The second track 516 crosses the first tracks 515 and is electrically conductively connected to the first tracks at the locations of the crossings. Fig. 5D shows a cross section of the planar inductive component 512 along a plane DD' depicted in Fig. 5C. Fig. 5D shows that the first track 515 and the second track 516 are symmetrical with respect to the mirror plane 514 and have an orientation in parallel with a substrate 513. Further it is shown that the first tracks 515 are situated between the second tracks 516 and the substrate 513. This is not required. For practical reasons it may be advantageous to have the second track 516 situated between the first tracks 515 and the substrate 513.

In a practical situation the first tracks 515 may be located in a poly-silicon layer, while the second track 516 is located in a metal layer.

It is not required for the first tracks 515 and the second tracks 516 to be located in the same layer. For the first tracks 515 the conductivity is much more critical than for the second tracks 516. The second track 516 basically provides a way to connect the first tracks 515 to a fixed DC potential, for instance ground. In practice it may by advantageous, for instance for layout reasons, to locate the first tracks 515 in a different layer than the second track 516.

The patterned ground shield 522 shown in top view in Fig. 5E comprises a plurality of first tracks 525 that are symmetrical with respect to a mirror plane 524 and have an orientation perpendicular to the mirror plane 524. The patterned ground shield 522 further comprises a second track 526 with an orientation in parallel with the mirror plane 524, further being symmetrical with respect to the mirror plane 524. The first tracks 525 and the second track 526 are situated in different planes that are parallel to each other. The second track 526 crosses the first tracks 525 and is electrically conductively connected to the first tracks at the locations of the crossings. The patterned ground shield 522 further comprises a plurality of third tracks 527 parallel to the first tracks and situated in a plane parallel to the plane in which the first tracks are situated. The first tracks 525 and third tracks 527 are electrically connected. Fig. 5F shows a cross section of the planar inductive component 522 along a plane EE' depicted in Fig. 5E. Fig. 5F shows that the first track 525 and the second track 526 are symmetrical with respect to the mirror plane 524 and have an orientation in parallel with a substrate 523. It is shown that the third tracks 527 are situated in a plane parallel to the plane in which the first tracks 525 are situated. Further it is shown that the first tracks 525 are situated between the second tracks 526 and the substrate 523. This is not required. For practical reasons it may be advantageous to have the second track 526 situated between the first tracks 525 and the substrate 523.

In a practical situation the first tracks may be formed in a metal layer, e.g. comprising aluminum and the third tracks may be formed in a buried N (BN) layer. The function of the first tracks is to increase the effective conductivity of the patterned ground shield in a direction perpendicular to the mirror plane 524. Electrical insulation between individual tracks in the buried N layer may be provided by deep trench isolation. This reduces the capacitive coupling between individual third tracks. To provide low ohmic electrical connections between a first track on top of a third track, so-called BN-taps are used. The distance from the metal of the winding of the inductive component to the BN layer is larger than the distance between the metal of the winding and the poly-silicon, resulting in a smaller capacitive coupling. Therefore, a patterned ground shield comprising third tracks realized in BN may be a better solution than a patterned ground shield comprising only first tracks realized in poly-silicon. A further improvement of the effect of the patterned ground shield 522 may be obtained if the length of the first tracks 525 is shorted so that these do not extend underneath the winding of the planar inductive component. In that case the first tracks 525 only help to decrease the effective resistance of the ground shield in the direction perpendicular to the mirror plane 524, without contributing to the parasitic coupling between the winding and the patterned ground shield.

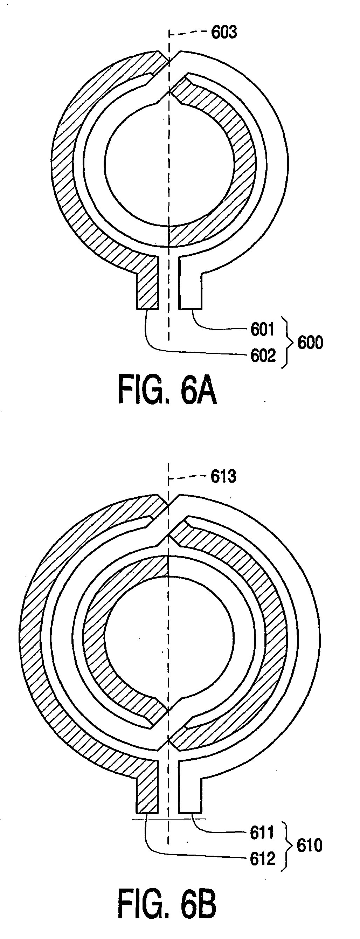

Figs. 6A-B show diagrams of top views of a further embodiment of a winding of planar inductive components according to the invention. Fig. 6A shows a winding 600, comprising a first sub-winding 601 and a second sub-winding 602. The first and second sub-windings 601, 602 are substantially spiral-shaped. The first and second sub-windings 601, 602 are symmetrical with respect to a mirror plane 603 with an orientation perpendicular to the winding 600, and are electrically connected in series. For differential mode operation it may be advantageous to provide a center tap at the location where the first and second sub-windings 601, 602 are connected with each other.

Fig. 6B shows a winding 610, comprising a first sub-winding 611 and a second sub-winding 612. The first and second sub-windings 601, 602 are substantially spiral-shaped. The first and second sub-windings 611, 612 are symmetrical with respect to a mirror plane 613 with an orientation perpendicular to the winding 610, and are electrically connected in series. For differential mode operation it may be advantageous to provide a center tap at the location where the first and second sub-windings 611, 612 are connected with each other.

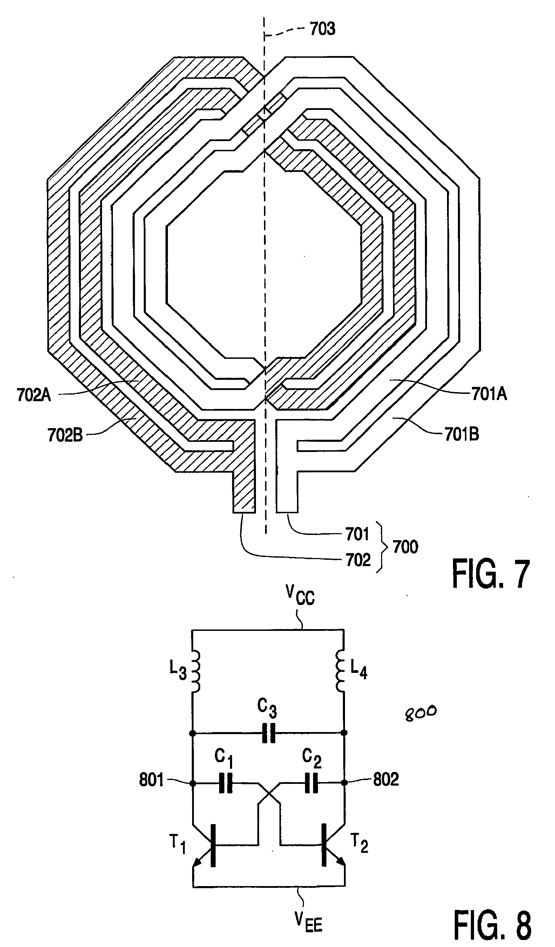

Fig. 7 shows a diagram of a top view of another further embodiment of a winding of a planar inductive component according to the invention. Fig. 7 shows a winding 700, comprising a first sub-winding 701 and a second sub-winding 702. The first and second sub-windings 701, 702 are substantially spiral-shaped. Furthermore, sub-winding 701 comprises two parallel tracks 701A, 702B, while sub-winding 702 comprises two parallel tracks 702A, 702B. The first and second sub-windings 701, 702 are symmetrical with respect to a mirror plane 703 with an orientation perpendicular to the winding 700, and are electrically connected in series. At the location where the sub-windings 701, 702 are connected, conductive track 701A is connected to conductive track 702B, while conductive track 701B is connected to conductive track 702A. In operation this gives a more uniform distribution of the current within the winding 700, thereby preventing current crowding, that leads to a higher effective resistance of the winding 700 and thus to a decrease in the quality factor of the planar inductive component. For differential mode operation it may be advantageous to provide a center tap at the location where the first and second sub-windings 701, 702 are connected with each other.

Fig. 8 shows a schematic diagram of an integrated circuit comprising planar inductive components according to the invention. The schematic diagram shown is a simplified schematic diagram of a voltage controlled oscillator (VCO). The VCO 800 comprises a first transistor T1, a second transistor T2, a first capacitor C1, a second capacitor C2, and a third capacitor C3, a first inductor L3 and a second inductor L4. The emitters of T1 and T2 are connected to the negative power supply VEE. The collector of T1 is connected to node 801, the collector of T2 to node 802. A first terminal of C1 is connected to node 801, a second terminal to the base of T2. A first terminal of C2 is connected to node 802, a second terminal to the base of T1. A first terminal of C3 is connected to node 801, a second terminal to node 802. A first terminal of L3 is connected to node 801, a second terminal to the positive power supply VCC. A first terminal of L4 is connected to node 802, a second terminal to VCC.

In practice L3 and L4 may be realized as sub-windings of a planar inductive component as shown in one of the Figs. 1, 2A-B, 6 and 7, provided with a center tap as discussed above. In the case of circuit 800 shown the center tap is connected to VCC, a first terminal of the inductive component to node 801 and a second terminal of the inductive component to node 802.

Summarizing, the invention relates to a planar inductive component arranged over a substrate 103. The substrate comprises a winding 101 situated in a first plane, a patterned ground shield 102, for shielding the winding 101 from the substrate 103. The winding 101 is at least substantially symmetrical with respect to a mirror plane 104 perpendicular to the first plane. The patterned ground shield 102 comprises a plurality of electrical conductive first tracks 105 situated in a first ground shield plane in parallel with the first plane. The first tracks have an orientation perpendicular to the mirror plane 104. Without the patterned ground shield 102 the winding 101 is capacitively coupled to the substrate 103. The substrate resistance results in a degradation of the quality factor of the inductive component 100. The patterned ground shield 102 shields the winding 101 from the substrate 103, thereby eliminating the degrading effect of the substrate. To prevent a reduction in the effective self inductance of the planar inductive component loop currents have to be prevented in the patterned ground shield, while at the same time transfer of charges induced in the mirrored halves of the winding 100 have to be facilitated. This is achieved by the first tracks 105.

The embodiments of the present invention described herein are intended to be taken in an illustrative and not a limiting sense. Various modifications may be made to these embodiments by persons skilled in the art without departing from the scope of the present invention as defined in the appended claims.

For instance a planar inductive component with a spiral-shaped winding is substantially symmetrical with respect to a symmetry axis.

For instance other types of transistors may be used instead of the bipolar transistors shown in Fig. 8. Furthermore it will be clear that many more integrated circuits applying (differential) inductive components may benefit from using a planar inductive component according to the invention.

## Claims

1. A planar inductive component (100) comprising:
a winding (101) situated in a first plane,
a patterned ground shield (102) for shielding the winding from a further layer (103), wherein
said winding is at least substantially symmetrical with respect to a mirror plane (104) perpendicular to said first plane, and said winding (101) comprises a first sub-winding with a first center, a second sub-winding with a second center, said first and second centers coinciding with each other, the shape of said second sub-winding being a mirror-image of the shape of said first sub-winding, and said first and second sub-windings being electrically connected In series, and
said patterned ground shield (102) comprises a plurality of electrical conductive first tracks (105) situated in a first ground shield plane in parallel with said first plane, said first tracks having an orientation perpendicular to said mirror plane, **characterised in that** each first track extends from one side of the mirror plane to the other side of the mirror plane.

2. A planar inductive component (100) as claimed in claim 1, **characterized in that** said first tracks (105) are at least substantially symmetrical with respect to said mirror plane.

3. A planar inductive component (100) as claimed in claim 1, **characterized In that** said patterned ground shield (102) comprises a second conductive track (206) with an orientation In parallel with said first plane that is symmetrical with respect to said mirror plane, and is electrically coupled to said first tracks.

4. A planar inductive component (100) as claimed in claim 3, **characterized in that** said second conductive track (206) is situated In said first ground shield plane.

5. An inductive component as claimed in claim 1, **characterised in that** said patterned ground shield (102) comprises a plurality of electrical conductive further tracks (527), situated in a further ground shield plane in parallel with said first ground shield plane, said further tracks having an orientation in parallel with said first tracks, and being electrically coupled to said first tracks.

6. An inductive component (100) as claimed in claim 5, **characterized in that** said further tracks (527) are at least substantially symmetrical with respect to said mirror plane.

7. An inductive component (100) as claimed in claim 1, **characterized in that** the first sub-winding (601) and the second sub-winding (602) are at least substantially spiral-shaped, and the first sub-winding (601) is intertwined with the second sub-winding (602).

8. An inductive component (100) as claimed in claim 1, **characterized in that** said winding (101) Is substantially circular. 10

9. An integrated circuit comprising a substrate (103), a planar inductive component (100) as claimed in any of the claims 1 to 8, said further layer being the substrate.

## Patentansprüche

1. Eine planare induktive Komponente (100) aufweisend:
eine Wicklung (101), welche sich in einer ersten Ebene befindet,
eine strukturierte Masse Abschirmung (102) zum Abschirmen der Wicklung von einer weiteren Schicht (103), wobei
die Wicklung zumindest im Wesentlichen symmetrisch in Bezug auf eine Spiegelebene (104) ist, welche senkrecht zu der ersten Ebene ist, und die Wicklung (101) aufweist
eine erste Teilwicklung mit einem ersten Mittelpunkt, eine zweite Teilwicklung mit einem zweiten Mittelpunkt, wobei der erste Mittelpunkt und der zweiten Mittelpunkt sich decken, wobei die Form der zweiten Teilwicklung ein Spiegelbild der Form der ersten Teilwicklung ist, und wobei die erste Teilwicklung und die zweite Teilwicklung in Serie elektrisch verbunden sind, und
wobei die strukturierte Masse Abschirmung (102) aufweist
eine Mehrzahl von elektrisch leitfähigen ersten Bahnen (105), welche sich in einer
ersten Masse Abschirmungsebene befinden, welche parallel zu der ersten Ebene ist,
wobei die ersten Bahnen eine Ausrichtung haben, welche senkrecht zu der Spiegelebene ist,
**dadurch gekennzeichnet, dass**
jede erste Bahn sich von einer Seite der Spiegelebene zu der anderen Seite der Spiegelebene erstreckt.

2. Eine planare induktive Komponente (100) gemäß Anspruch 1,
**dadurch gekennzeichnet, dass**
die ersten Bahnen (105) zumindest im Wesentlichen symmetrisch in Bezug auf die Spiegelebene sind.

3. Eine planare induktive Komponente (100) gemäß Anspruch 1,
**dadurch gekennzeichnet, dass**
die strukturierte Masse Abschirmung (102) aufweist
eine zweite leitfähige Bahn (206) mit einer Ausrichtung, welche parallel zu der ersten Ebene ist, welche symmetrisch ist in Bezug auf die Spiegelebene, und welche mit den ersten Bahnen elektrisch gekoppelt ist.

4. Eine planare induktive Komponente (100) gemäß Anspruch 3,
**dadurch gekennzeichnet, dass**
die zweite leitfähige Bahn (206) sich in der ersten Masse Abschirmungsebene befindet.

5. Eine induktive Komponente gemäß Anspruch 1,
**dadurch gekennzeichnet, dass**
die strukturierte Masse Abschirmung (102) aufweist
eine Mehrzahl von elektrisch leitfähigen weiteren Bahnen (527), welche sich in einer weiteren Masse Abschirmungsebene befinden, welche parallel ist zu der ersten Masse Abschirmungsebene, wobei die weiteren Bahnen eine Ausrichtung haben, welche parallel zu den ersten Bahnen ist, und mit den ersten Bahnen elektrisch gekoppelt sind.

6. Eine induktive Komponente (100) gemäß Anspruch 5,
**dadurch gekennzeichnet, dass**
die weiteren Bahnen (527) zumindest im Wesentlichen symmetrisch in Bezug auf die Spiegelebene sind.

7. Eine induktive Komponente (100) gemäß Anspruch 1,
**dadurch gekennzeichnet, dass**
die erste Teilwicklung (601) und die zweite Teilwicklung (602) zumindest im Wesentlichen spiralförmig sind, und
die erste Teilwicklung (601) und die zweite Teilwicklung (602)
ineinandergreifen.

8. Eine induktive Komponente (100) gemäß Anspruch 1,
**dadurch gekennzeichnet, dass**
die Wicklung (101) im Wesentlichen kreisförmig ist.

9. Ein integrierter Schaltkreis aufweisend
ein Substrat (103),
eine planare induktive Komponente (100) gemäß irgendeinem der Ansprüche 1 bis 8, wobei die weitere Schicht das Substrat ist.

## Revendications

1. Composant inductif plan (100) comportant :
un enroulement (101) situé dans un premier plan,
un blindage (102) de masse avec motif servant à protéger l'enroulement d'une couche supplémentaire (103),
ledit enroulement étant au moins sensiblement symétrique par rapport à un plan (104) de réflexion perpendiculaire audit premier plan, et ledit enroulement (101) comportant un premier sous-enroulement doté d'un premier centre, un deuxième sous-enroulement doté d'un deuxième centre, lesdits premier et deuxième centres coïncidant entre eux, la forme dudit deuxième sous-enroulement étant une image par réflexion de la forme dudit premier sous-enroulement, et lesdits premier et deuxième sous-enroulements étant reliés électriquement en série, et
ledit blindage (102) de masse avec motif comportant une pluralité de premières pistes électriquement conductrices (105) situées dans un premier plan de blindage de masse parallèlement audit premier plan, lesdites premières pistes présentant une orientation perpendiculaire audit plan de réflexion, **caractérisé en ce que** chaque première piste s'étend d'un côté du plan de réflexion à l'autre côté du plan de réflexion.

2. Composant inductif plan (100) selon la revendication 1, **caractérisé en ce que** lesdites premières pistes (105) sont au moins sensiblement symétriques par rapport audit plan de réflexion.

3. Composant inductif plan (100) selon la revendication 1, **caractérisé en ce que** ledit blindage (102) de masse avec motif comporte une deuxième piste conductrice (206) présentant une orientation parallèle audit premier plan qui est symétrique par rapport audit plan de réflexion et est couplée électriquement auxdites premières pistes.

4. Composant inductif plan (100) selon la revendication 3, **caractérisé en ce que** ladite deuxième piste conductrice (206) est située dans ledit premier plan de blindage de masse.

5. Composant inductif selon la revendication 1, **caractérisé en ce que** ledit blindage (102) de masse avec motif comporte une pluralité de pistes supplémentaires électriquement conductrices (527), situées dans un plan de blindage de masse supplémentaire parallèlement audit premier plan de blindage de masse, lesdites pistes supplémentaires présentant une orientation parallèle auxdites premières pistes et étant couplées électriquement auxdites premières pistes.

6. Composant inductif (100) selon la revendication 5, **caractérisé en ce que** lesdites pistes supplémentaires (527) sont au moins sensiblement symétriques par rapport audit plan de réflexion.

7. Composant inductif (100) selon la revendication 1, **caractérisé en ce que** le premier sous-enroulement (601) et le deuxième sous-enroulement (602) sont au moins sensiblement en forme de spirale, et **en ce que** le premier sous-enroulement (601) s'interpénètre avec le deuxième sous-enroulement (602).

8. Composant inductif (100) selon la revendication 1, **caractérisé en ce que** ledit enroulement (101) est sensiblement circulaire.

9. Circuit intégré comportant un substrat (103), un composant inductif plan (100) selon l'une quelconque des revendications 1 à 8, ladite couche supplémentaire étant le substrat.
